# EUROPÄISCHE PATENTSCHRIFT

(11) **EP 4 467 376 B1**
(45) Veröffentlichungstag und Bekanntmachung des Hinweises auf die Patenterteilung: **25.03.2026**
(21) Anmeldenummer: 24177280.5
(22) Anmeldetag: 22.05.2024
(51) Int. Cl.: B60K 35/10, B60K 35/25, B60K 35/53, H03K 17/96, H03K 17/965, H03K 17/97

(54) **BEDIENEINHEIT FÜR EIN FAHRZEUG, INSBESONDERE FÜR DIE BEDIENUNG EINER ODER MEHRERER KOMPONENTEN DES FAHRZEUGS**
OPERATING UNIT FOR A VEHICLE, IN PARTICULAR FOR OPERATING ONE OR MORE COMPONENTS OF THE VEHICLE
UNITÉ DE COMMANDE POUR UN VÉHICULE, EN PARTICULIER POUR LA COMMANDE D'UN OU PLUSIEURS COMPOSANTS DU VÉHICULE

(30) Priorität: 22.05.2023 DE 102023113246
(43) Veröffentlichungstag der Anmeldung: 27.11.2024
(73) Patentinhaber: AUO Mobility Solutions Germany GmbH, 59557 Lippstadt (DE)
(72) Erfinder: BESCHNITT, Alexander, 59557 Lippstadt (DE); KEMPPINEN, Pasi, 59557 Lippstadt (DE)
(74) Vertreter: dompatent

(56) Entgegenhaltungen:
- WO-A1-2016/012241
- WO-A1-2016/012243
- DE-A1- 102013 006 415
- DE-A1- 102020 127 418
- US-A1- 2015 291 034

## Beschreibung

Die Erfindung betrifft eine Bedieneinheit für ein Fahrzeug, insbesondere für die Bedienung einer oder mehrerer Komponenten des Fahrzeugs, wie z.B. eine zentrale Eingabevorrichtung (CID). Die Bedieneinheit kann mit oder ohne Anzeigevorrichtung ausgebildet sein.

Zentrale Eingabevorrichtungen mit oder ohne Anzeigeeinheit für Fahrzeuge sind im Stand der Technik bekannt. Bedieneinheiten des Typs, auf den sich die Erfindung bezieht, weisen eine Bedienleiste auf, die über die Vorder- bzw. Oberseite eines Gehäuses übersteht. Beispiele für derartige Bedieneinheiten sind in WO 2016/012241 A1 und WO 2016/012243 A1 beschrieben.

Um mit manuell betätigbaren Bedienleisten eine möglichst große Anzahl von Bedienfunktionen ausführen zu können, sollten diese Bedienleisten relativ lang sein. Nachteilig bei relativ langen Bedienleisten ist der Aufwand mechanischer und konstruktiver Art, der betrieben werden muss, um sicherzustellen, dass sich die Bedienleiste unabhängig davon, an welcher Stelle sie (durch Drücken oder Ziehen) betätigt wird, hinsichtlich ihrer Kinematik möglichst gleich verhält. Denn es soll durch eine Sensorik unabhängig vom Betätigungsort der Bedienleiste zuverlässig erkannt werden können, dass die Bedienleiste valide gedrückt ist, d.h. dergestalt gedrückt ist, dass die beabsichtigte Bedienfunktion ausgelöst wird.

Lange Bedienleisten neigen dazu, sich zu verformen, bevor die Bedienleiste selbst so stark betätigt worden ist, dass eine Sensorik eine valide Betätigung der Bedienleiste sensiert. Durch Vorsehen mehrerer über die Länge der Bedienleiste verteilt angeordneter Kraft- bzw. Wegsensoren kann unter Inkaufnahme eines erhöhten elektronischen Hardware- sowie Software-Aufwands kompensiert werden, dass die Bedienleiste sich je nach Betätigungsort unterschiedlich verhält, bis es zur Erkennung einer validen Betätigung der Bedienleiste kommt. Dies ist allerdings mit nicht unerheblichem konstruktivem und Montageaufwand verbunden.

Aufgabe der Erfindung ist es, eine Bedieneinheit für ein Fahrzeug, insbesondere für die Bedienung einer oder mehrerer Komponenten eines Fahrzeugs, wie z.B. zentrale Eingabevorrichtung (CID), zu schaffen, die über eine einfachere Lagerung einer bewegbaren Bedienleiste verfügt.

Zur Lösung dieser Aufgabe wird mit der Erfindung eine Bedieneinheit für ein Fahrzeug, insbesondere für die Bedienung einer oder mehrerer Komponenten des Fahrzeugs, wie z.B. zentrale Eingabevorrichtung (CID) vorgeschlagen, wobei die Bedieneinheit versehen ist mit
- einem Gehäuse, das eine Vorderseite aufweist,
- einer über die Vorderseite vorstehenden, zwischen einer Ruheposition und einer Betätigungsposition bewegbaren Bedienleiste, die eine Bedienfläche mit mehreren in Längserstreckung der Bedienleiste sowie zwischen zwei Lateralenden der Bedienleiste nebeneinander angeordneten, manuell oder mittels eines Betätigungsobjekts betätigbaren Bedienfeldern für die Auslösung von Bedienfunktionen aufweist,
- einer Sensorik zur Erkennung einer validen Betätigung der Bedienleiste,
- einem mit der Bedienleiste verbundenen Trägerelement, das sich ausgehend von der Bedienleiste weiter in das Gehäuse hinein erstreckt und ein der Bedienleiste abgewandtes hinteres Ende sowie zwei zu den Lateralenden der Bedienleiste benachbarte Seitenenden aufweist, und
- einer in dem Gehäuse angeordneten Lagerungsvorrichtung zur beweglichen Lagerung des Trägerelements bei sich aus der Ruheposition in die Betätigungsposition sowie bei sich zurückbewegenden Bedienleiste, wobei das Trägerelement an der Lagerungsvorrichtung rückstellfähig beweglich gelagert ist,
- wobei die Lagerungsvorrichtung mindestens ein hinteres Lagerungselement für das hinteren Ende des Trägerelements und mindestens ein vorderes Lagerungselement aufweist, das mit dem der Bedienleiste zugewandten Ende des Trägerelements und/oder mit der Bedienleiste zusammenwirkt und elastisch ausgebildet ist, und
- wobei das mindestens eine oder jedes hintere Lagerungselement eine elastisch tordierbare Strebe mit einer Längsachse aufweist, die sich im Wesentlichen parallel zu einer die beiden Lateralenden der Bedienleiste verbindenden, gedachten Verbindungslinie zwischen einem Befestigungsende des hinteren Lagerungselements, an dem die Strebe innerhalb des Gehäuses starr befestigt ist, und einem Verbindungende des hinteren Lagerungselements, an dem die Strebe mit dem hinteren Ende des Trägerelements starr verbunden ist, erstreckt.

Die erfindungsgemäße Bedieneinheit weist ein Gehäuse auf, das eine Vorder- oder Oberseite aufweist (nachfolgend wird stets von Vorderseite gesprochen), über die eine Bedienleiste vorsteht, die eine Bedienfläche mit mehreren in Längserstreckung der Bedienleiste sowie zwischen zwei Lateralenden der Bedienleiste nebeneinander angeordneten, manuell oder mittels eines Betätigungsobjekt betätigbaren Bedienfeldern für die Auslösung von Bedienfunktionen aufweist. Die Bedienleiste ist zwischen einer Ruheposition und einer Betätigungsposition bewegbar, und zwar um eine Rotationsachse, die auch virtuell sein kann, bewegbar. Die Bedienleiste ist mit einem Trägerelement verbunden oder Teil eines Trägerelements, das sich ausgehend von der Bedienleiste in das Gehäuse hinein erstreckt bzw. in dem Gehäuse erstreckt, wobei das hintere Ende des Trägerelements einen möglichst großen Abstand zur Bedienleiste aufweisen sollte. Im Gehäuse ist eine Lagerungsvorrichtung vorgesehen, über die das Trägerelement zwischen seiner Ruheposition und seiner Betätigungsposition bewegbar gelagert ist, wobei diese Lagerung rückstellfähig ausgebildet ist, so dass nach einer Betätigung der Bedienleiste diese aus ihrer Betätigungsposition selbsttätig zurück in die Ruheposition gelangt. Die Lagerungsvorrichtung weist mindestens ein hinteres Lagerungselement für das hintere Ende des Trägerelements und mindestens ein vorderes Lagerungselement auf, das mit dem der Bedienleiste zugewandten (vorderen) Ende des Trägerelements und/oder mit der Bedienleiste selbst zusammenwirkt und wie das hintere Lagerungselement elastisch ausgebildet ist. Die Lagerungselemente können integraler Bestandteil des Trägerelements und/oder der Bedienleiste sein.

Das hintere Lagerungselement weist mindestens eine elastisch tordierbare Strebe auf, die eine Längsachse und damit eine Längserstreckung aufweist. Die Längsachse der mindestens einen tordierbaren elastischen Strebe verläuft parallel zu einer gedachten Verbindungslinie zwischen den beiden Lateralenden der Bedienleiste. Zwischen diesen beiden Lateralenden kann die Bedienleiste beispielsweise aus designerischen Gründen bogenförmig oder aber auch geradlinig verlaufen. Innerhalb des Gehäuses ist die Strebe an einem ihrer Enden, nämlich am Befestigungsende, starr mit dem Gehäuse verbunden und dort befestigt, während ihr anderes Ende, nämlich ihr Verbindungsende, mit dem hinteren Ende des Trägerelements starr verbunden ist.

Wird die Bedienleiste gedrückt oder wird an der Bedienleiste gezogen oder wird sie geschoben, um aus ihrer Ruheposition in die Betätigungsposition überführt zu werden, kommt es zu einer Tordierung der mindestens einen Strebe des hinteren Lagerungselements. Die Zurückbewegung in die Ruheposition der Bedienleiste kann unterstützt werden durch das mindestens eine vordere Lagerungselement, das ebenfalls elastisch ausgebildet ist. Durch die tordierbaren Streben wird eine gleichbleibende, vom Betätigungsort auf der Bedienleiste unabhängige Schwenk- bzw. Rotationsbewegung der Bedienleiste erzielt, wobei die Rotationsachse innerhalb der Strebe oder zumindest nahe der Strebe verläuft (im letztgenannten Fall als gedachte Rotationsachse).

Für die Erhöhung der Stabilisierung der Rotations- bzw. Schwenkbewegung der Bedienleiste ist es von Vorteil, wenn die Bedienleiste bzw. das Trägerelement zwei vordere Lagerungselement aufweist, die im Bereich der Seitenenden des Trägerelements und/oder der Lateralenden der Bedienleiste angeordnet sind.

Für weitere Stabilisierung der unabhängig vom Betätigungsort möglichst gleichbleibenden Kinematik von Trägerelement, Bedienelement und Lagerungsvorrichtung ist es von Vorteil, wenn sich am hinteren Ende des Trägerelements mindestens zwei hintere Lagerungselemente befinden, die jeweils eine tordierbare elastische Strebe aufweisen.

Die elastisch tordierbare Strebe jedes hinteren Lagerungselements ist zweckmäßigerweise als Stab mit rundem oder mit mehreckigem Querschnitt ausgebildet. Das gesamte hintere Ende des Trägerelements sowie vorteilhafterweise das Trägerelement selbst kann aus elastisch verformbarem Kunststoff bestehen, wobei die Kunststoffkonstruktion ausreichend versteift ist, um den gewünschten Effekt, nämlich eine Bewegung um eine Rotationsachse, zu ermöglichen. Alternativ zu einer Kunststoffausführung jedes hinteren Lagerungselements bzw. des hinteren Endes des Trägerelements kann jedes hintere Lagerungselement auch eine Blattfeder aus Metall, vorzugsweise aus Federstahl aufweisen. Diese Blattfeder ist bevorzugt im Wesentlichen vertikal und damit hochstehend ausgerichtet, so dass ihre beiden Hauptseitenflächen einerseits in Richtung auf die Bedienleiste (gilt für die zum Trägerelement weisende Hauptseitenfläche) und andererseits von der Bedienleiste weg gerichtet weisen. Diese zuvor mit "vertikal" bezeichnete Ausrichtung des als Flachmaterialstreifen (aus Federstahl oder aber auch aus Kunststoff) ausgebildete Strebe wird im Rahmen der Erfindung auch dann noch als "vertikal" ausgerichtet betrachtet, wenn sie gegenüber der Vertikalen um weniger als 45° gekippt ausgerichtet ist.

Die insoweit mit "vertikal" bezeichnete Ausrichtung des Flachmaterialstreifens aus Metall, insbesondere Federstahl bzw. Kunststoff, verwindet sich also zwischen ihren beiden Enden, nämlich zwischen ihrem Befestigungsende am Gehäuse und ihrem Verbindungsende am Trägerelement. Diese Verwindungs- bzw. Torsionsbewegung unterscheidet sich von der elastischen Verformung des Flachmaterialstreifens, wenn dieser horizontal angeordnet wäre.

In dem Falle, dass die Strebe als vertikal ausgerichteter Flachmaterialstreifen ausgeführt ist, existiert bei der Torsion also im Wesentlichen eine Achse innerhalb des Flachmaterialstreifens, bzgl. dessen der auf der eine Seite des Flachmaterialstreifens liegende Teil in einer Richtung verformt wird, die entgegengesetzt zu der Verformungsrichtung des gegenüberliegenden Flachmaterialstreifenabschnitts ist.

Wie zuvor beschrieben, ist es also vorteilhaft, wenn die Strebe des mindestens einen oder jedes hinteren Lagerungselements als Flachmaterialstreifen mit zwei Hauptseitenflächen ausgebildet ist, wobei die Hauptseitenflächen des Flachmaterialstreifens vertikal oder gegenüber der Vertikalen um weniger als 45° gekippt ausgerichtet sind.

Wie bereits oben beschrieben, kann es von Vorteil sein, wenn die Lagerungsvorrichtung zwei hintere Lagerungselemente aufweist, deren beide Streben sich von einem gemeinsamen Befestigungsende aus in entgegengesetzten Richtungen zu ihren jeweiligen Verbindungsenden erstrecken, an denen sie mit dem hinteren Ende des Trägerelements starr verbunden sind. In diesem Fall erstrecken sich die beiden Streben von einem gemeinsamen, im Wesentlichen in der Mitte zwischen beiden Streben angeordneten, Befestigungsende aus in entgegengesetzter Richtung zu ihren jeweiligen Verbindungsenden. Hierbei ist es mit Vorteil möglich, dass die beiden Streben an ihren Befestigungsenden zur Bildung einer gemeinsamen Strebe einstückig miteinander verbunden sind und einen Mittenbefestigungsabschnitt der gemeinsamen Strebe definieren, von dem aus sich die gemeinsame Strebe in zwei zueinander entgegengesetzten Richtungen zu ihren mit dem Trägerelement verbundenen Verbindungsenden erstreckt. Die Strebe hat sozusagen zwei diametral gegenüberliegende und voneinander weg weisende Arme.

Diese Konstruktion kann auch, ohne dass sich die Kinematik und Dynamik verändert, invers aufgebaut sein, indem nämlich die beiden Streben zweier hinterer Lagerungselemente an ihren mit dem Trägerelement verbundenen Verbindungsende zusammengeführt sind, um sich von diesem Verbindungsende aus in zueinander entgegengesetzten Richtungen bis zu ihren jeweiligen Befestigungsenden zu erstrecken. Auch diesbezüglich ist es zweckmäßig, wenn die beiden Streben an ihren Verbindungsenden zur Bildung einer gemeinsamen Strebe einstückig miteinander verbunden sind und einen Mittenverbindungsabschnitt der gemeinsamen Strebe definieren, innerhalb dessen die gemeinsame Strebe mit dem Trägerelement verbunden ist und von dem aus sich die gemeinsame Strebe in zwei zueinander entgegengesetzten Richtungen zu ihren innerhalb des Gehäuses direkt oder indirekt starr befestigten Befestigungsenden erstreckt.

In weiterer vorteilhafter Ausgestaltung der Erfindung kann vorgesehen sein, dass das Trägerelement nach Art einer Platte ausgebildet ist, die bezogen auf die Längserstreckung der Bedienleiste mittenzentriert zu dieser angeordnet ist.

Alternativ zu der zuvor beschriebenen Ausgestaltung der Erfindung ist es möglich, dass das Trägerelement zwei mit der Bedienleiste verbundene Trägerarme aufweist, die symmetrisch zu einer quer zur Erstreckung der Bedienleiste durch deren Mitte verlaufende, gedachten Symmetrielinie angeordnet sind, wobei an jedem Trägerarm an dessen jeweils der Bedienleiste abgewandten hinteren Ende ein hinteres Lagerungselement angeordnet ist.

Wie bereits oben beschrieben, kann es zweckmäßig sein, wenn die Lagerungsvorrichtung zwei vordere Lagerungselemente aufweist, die an den beiden Lateralseiten des Trägerelements oder den beiden Lateralenden der Bedienleiste einander gegenüberliegend angeordnet sind.

Ferner kann es von Vorteil sein, wenn das mindestens eine oder jedes hintere Lagerungselement integraler Bestandteil des hinteren Endes des Trägerelements oder, sofern das Trägerelement Trägerarme aufweist, integraler Bestandteil der hinteren Enden der Trägerarme des Trägerelements ist.

Wie ebenfalls bereits vorab ausgeführt, ist es zweckmäßig und von Vorteil, wenn die Strebe des mindestens einen oder jedes hinteren Lagerungselements als Blattfeder ausgebildet ist, die alternativ aus Kunststoff oder Federstahl oder einem anderen federelastischen Material ausgebildet ist.

In weiterer vorteilhafter Ausgestaltung der Erfindung kann vorgesehen sein, dass die Feder des mindestens einen oder jedes vorderen Lagerungselements als Blattfeder aus Kunststoff oder Federstahl oder als Schraubenfeder aus Kunststoff oder Federstahl ausgebildet ist.

Wie bereits oben ausgeführt, bedarf es für die Erkennung einer validen Betätigung der Bedienleiste einer Sensorik zur Erfassung eines vorgegebenen Mindestbewegungsgrades der Bedienleiste aus dessen Ruheposition in die somit definierte Betätigungsposition. Hierzu kann mit Vorteil vorgesehen sein, dass diese Sensorik mindestens zwei Kraft- und/oder Wegsensoren zur Erfassung der Kraft, die bei Betätigung der Bedienleiste auf diese einwirkt, und/oder des Weges, um den sich die Bedienleiste bei Betätigung bewegt, und eine Auswerteeinheit aufweist, die von den Sensoren Messsignale empfängt und anhand dieser Messsignale ein die Betätigungsposition auf der Bedienleiste repräsentierendes Signal und ein eine valide Betätigung der Bedienleiste repräsentierendes Signal erzeugt. Die von den mindestens zwei und vorzugsweise bis zu fünf Sensoren gelieferten Messwerte sind für jede Betätigungsposition auf der Bedienleiste charakteristisch, so dass man aus dem "Messwertbild" der Kraft- bzw. Wegsensoren ablesen kann, an welcher Stelle die Bedienleiste betätigt worden ist.

Alternativ dazu kann die Bedienleiste als Positionserkennungssensorik eine in der oder auf der Bedienleiste angeordnete berührungssensitive Folie aufweisen, die bei Berührung und/oder Betätigung der Bedienleiste ein die Betätigungsposition repräsentierendes Signal ausgibt, sowie mindestens einen Kraft- und/oder Wegsensor zur Erfassung der Kraft, die bei Betätigung der Bedienleiste auf diese einwirkt, und/oder des Weges, um den sich die Bedienleiste bei Bestätigung bewegt, und eine Auswerteeinheit aufweisen, die von dem mindestens einen Sensor und der berührungssensitiven Folie Signale empfängt und anhand dieser Signale ein die Betätigungsposition auf der Bedienleiste repräsentierendes Signal und ein eine valide Betätigung der Bedienleiste repräsentierendes Signal erzeugt.

Die erfindungsgemäße Bedieneinheit kann vorteilhafterweise versehen sein mit
- einer Anzeigeeinheit mit einer oberhalb und/oder unterhalb der Bedienleiste angeordneten Anzeigefläche zur Anzeige von alphanummerischer und/oder grafischer Information betreffend die dem jeweiligen Betätigungsfeld zugeordneten Bedienfunktionen oder
- einer in der Bedienleiste integrierten Anzeigeeinheit mit Anzeigefläche zur Anzeige von alphanummerischer und/oder grafischer Information betreffend die dem jeweiligen Bedienfeld zugeordnete Bedienfunktion oder
- unveränderbarer alphanummerischer und/oder grafischer Information, z.B. in Form von Symbolen, Icons o.dgl. auf der Bedienleiste.

Schließlich ist es für den Komfort der Betätigung der Bedienleiste vorteilhaft, wenn die Bedieneinheit eine passive oder eine aktive Haptik-Rückmeldeeinheit zur Erzeugung einer akustischen und/oder taktilen Rückmeldung bei einer gültigen Betätigung der Bedienleiste aufweist. Die passive Haptik-Rückmeldeeinheit könnte beispielsweise durch einen mechanischen Schalter realisiert werden, der neben seiner Haptik bei Betätigung auch dazu genutzt werden könnte, eine valide Betätigung der Bedienleiste zu signalisieren. Bei einer aktiven Haptik-Rückmeldeeinheit wird das Trägerelement oder die Bedienleiste mechanisch pulsförmig angeregt, was durch einen Aktuator, beispielsweise einen Piezoaktuator oder einen elektromagnetisch arbeitenden Aktuator realisiert werden kann.

Die Erfindung wird nachfolgend anhand mehrerer Ausführungsbeispiele sowie unter Bezugnahme auf die Zeichnungen näher erläutert. Im Einzelnen zeigen dabei:
- Fig. 1: perspektivisch eine Bedieneinheit, in der die Erfindung in mehreren Ausführungsformen realisiert sein kann,
- Fig. 2: einen Horizontalschnitt entsprechend der Ebene II-II der Figur 1 zur Darstellung eines ersten Ausführungsbeispiels der Lagerung von Trägerelement und Bedienleiste,
- Fig. 3: eine perspektivische Darstellung des Trägerelements mit angedeuteter elastischer Lagerung,
- Fig. 4: eine Schnittansicht ähnlich der gemäß Figur 2 für eine Variante der Bedienleiste bzw. des Trägerelements und
- Fig. 5 bis Fig. 11: schematisch weitere Ausgestaltungen insbesondere der hinteren Lagerung des Trägerelements, die auf Kunststoffbasis ausgebildet sind.

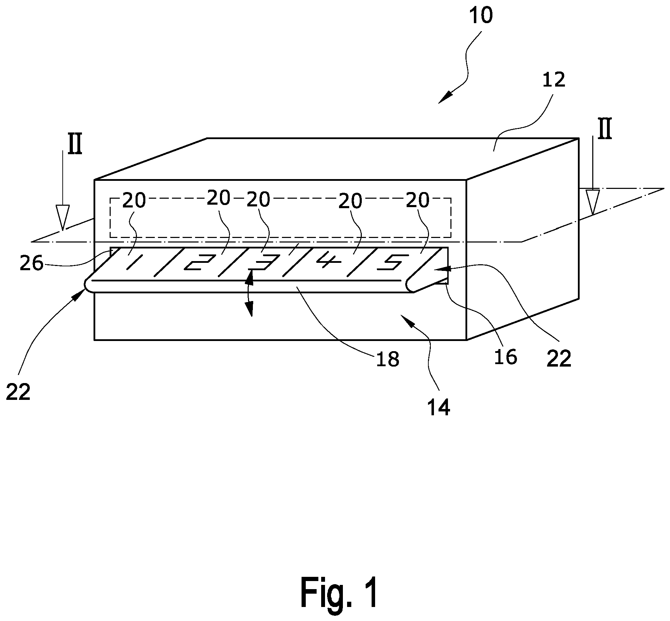

Fig. 1 zeigt perspektivisch die Ansicht auf eine Bedieneinheit 10, die ein Gehäuse 12 mit einer Vorderseite 14 aufweist. Aus einer Öffnung 16 der Vorderseite 14 des Gehäuses 12 steht eine Bedienleiste 18 hervor, die durch Drücken aus ihrer in Fig. 1 gezeigten Ruheposition in eine Betätigungsposition überführt werden kann. Genauso kann die Bedienleiste 18 aber auch durch Anheben aus der gezeigten Ruheposition in die Betätigungsposition überführt werden. Schließlich ist es auch möglich, dass die Bedienleiste 18 sowohl durch Drücken als auch durch Anheben aus ihrer Mitten- bzw. Ruheposition in zwei unterschiedliche Betätigungspositionen überführt werden kann. Der Grad der Bewegung der Bedienleiste zwischen der Ruheposition und der oder jeder Betätigungsposition ist typischerweise recht gering.

Die Bedienleiste 18 weist mehrere Bedienfelder 20 (im Ausführungsbeispiel fünf Bedienfelder) auf, die nebeneinander zwischen den beiden Lateralenden 22 der Bedienleiste 18 liegen.

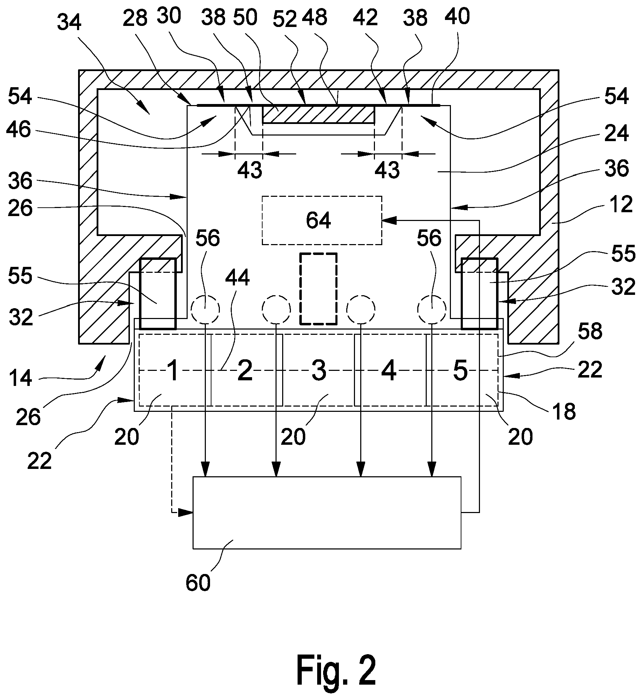

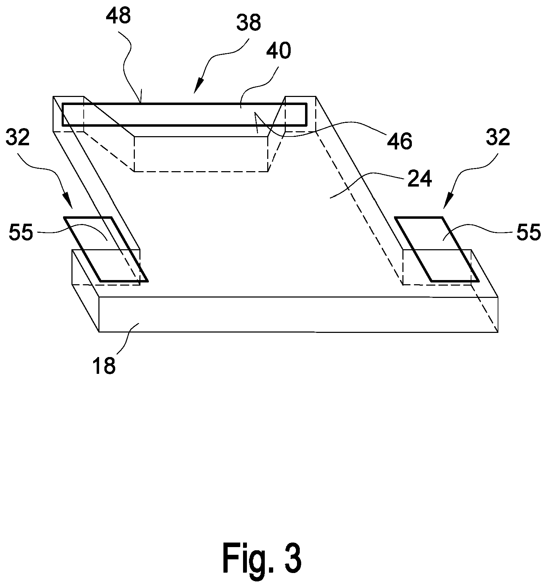

In den Fign. 2 und 3 ist zu erkennen, dass die Bedienleiste 18 von einem Trägerelement 24 gehalten ist, das sich ausgehend von der Bedienleiste 18 weiter in das Gehäuse 20 hinein erstreckt, wozu dieses an seiner Vorderseite 14 eine Öffnung 26 aufweist. Innerhalb des Gehäuses 12 ist das Trägerelement 24 an seinem hinteren Ende 28 gelagert. Hierzu dient in diesem Ausführungsbeispiel ein hinteres Lagerungselement 30, auf das später noch eingegangen werden wird. Das hintere Lagerungselement 30 ist zusammen mit mindestens einem (in diesem Ausführungsbeispiel zwei) vorderen Lagerungselement 32 Teil einer Lagerungsvorrichtung 34. Die vorderen Lagerungselemente 32 befinden sich an den Seitenrändern 36 des Trägerelements 24 im Bereich der Bedienleiste 18, und zwar im Bereich der Lateralenden 22 der Bedienleiste 18. In Fig. 2 ist gestrichelt die Positionierung eines weiteren vorderen Lagerungselements 32 gezeigt, wobei alternativ das im Ausführungsbeispiel der Fig. 2 in Höhe der Mitte der Bedienleiste 18 angeordnete Lagerungselement (gestrichelt angedeutet) das einzige vordere oder ein zusätzliches vorderes Lagerungselement sein kann.

In diesem Ausführungsbeispiel ist das hintere Lagerungselement 30 jeweils als tordierbare Strebe 38 in Form eines Flachmaterialstreifens 40 aus Federstahl, also als Blattfeder 42, ausgebildet. Der Flachmaterialstreifen 40 jeder Blattfeder 42 ist vertikal ausgebildet und erstreckt sich parallel zu einer gedachten Verbindungslinie 44 zwischen den beide Lateralenden 22 der Bedienleiste 18. In der Mitte jeder Blattfeder 42 ist diese auf eine ihrer Hauptseitenflächen 46,48 an einem Befestigungsblock o.dgl. Befestigungselement 50 innerhalb des Gehäuses 12 starr befestigt. Beidseitig dieses Befestigungselements 50 erstreckt sich die Blattfeder 42 und bildet zwei tordierbare elastische Streben 38. Die beiden Streben 38 sind also einteilig ausgebildet, wobei die Blattfeder 42 in ihrem Mittenabschnitt die Befestigungsenden 52 der beiden Streben 38 bildet, während die in entgegengesetzten Richtungen verlaufenden Blattfederabschnitte an ihren beiden entgegengesetzten Enden die Verbindungsenden 54 jeder Strebe mit dem hinteren Ende 28 des Trägerelements 24 bilden. An den Verbindungsenden 54 sind die Streben 38 starr mit dem Trägerelement 24 verbunden. Durch Wahl des Materials der Streben 38, deren geometrische Form und/oder der Länge der "freiliegenden" und somit tordierbaren Bereiche 43 der Blattfeder 42 bestimmt sich der Grad der Tordierbarkeit und Elastizität der Streben 38.

Die vorderen Lagerungselemente 32 erstrecken sich zwischen der Bedienleiste 28 bzw. dem Trägerelement 24 und dem Gehäuse. Die als Blattfedern 55 in Form von Federzungen ausgebildeten elastischen vorderen Lagerungselemente 32 unterstützen neben dem bzw. jedem hinteren Lagerungselement 30 eine Zurückbewegung der betätigten Bedienleiste 18, wie nachfolgend beschrieben wird.

Wie man anhand der Fig. 2 erkennen kann, liegt die Blattfeder 42 in ihrem Bereich 43 zwischen den Verbindungsenden 54 und den Befestigungsenden 52 der Streben 38 frei, so dass die Blattfeder 42 in diesen freiliegenden Bereichen tordiert, wenn die Bedienleiste 18 durch Drücken oder Ziehen (oder Anheben) betätigt wird. Bei diesem Vorgang verformen sich auch die Blattfedern 55 der vorderen Lagerungselemente 32. Bei Aufhebung der Betätigungskraft bewegt sich die Bedienleiste 18 dann automatisch wieder zurück in ihre Ruheposition, wofür einerseits die Blattfeder 55 der hinteren Lagerungselemente 30 und die Blattfedern 42 der vorderen Lagerungselemente 32 sorgen.

Fig. 3 zeigt nochmals perspektivisch das Trägerelement 24 mit Bedienleiste 18 und die Anordnung der verschiedenen Blattfedern 42,55 am hinteren Ende des Trägerelements 24 (ohne Befestigungselement 50 des Gehäuses) sowie an dessen seitlichem Rand.

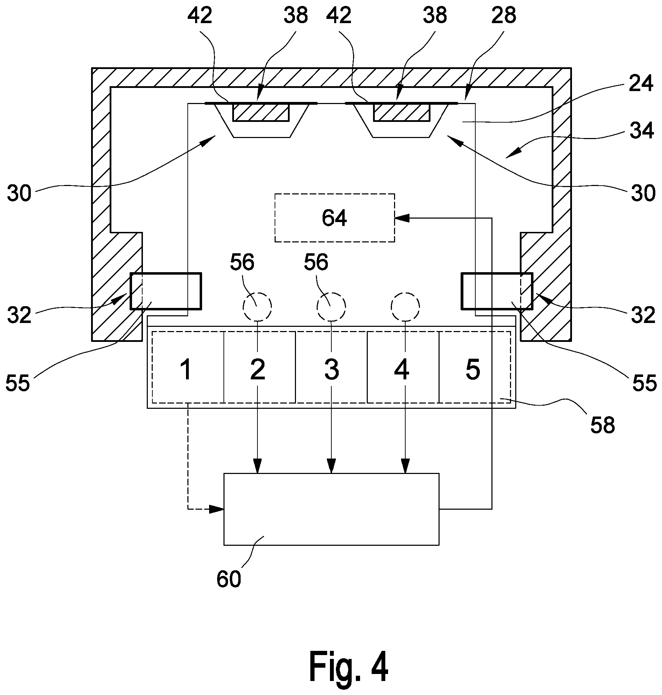

Fig. 4 zeigt eine Variante der Lagerungsvorrichtung 34 des Ausführungsbeispiels nach den Fign. 2 und 3. Sofern in diesem Ausführungsbeispiel die Bestandteile der Bedienvorrichtung konstruktiv oder funktional gleich denen der Bedieneinheit gemäß den Fign. 2 und 3 sind, sind sie in Fig. 4 mit den gleichen Bezugszeichen versehen wie in den Fign. 2 und 3.

Die Blattfedern 55 der vorderen Lagerungselemente 32 sind gegenüber der Ausrichtung beim Ausführungsbeispiel nach den Fign. 2 und 3 um 90° verdreht. Am hinteren Ende 28 des Trägerelements 24 befinden sich zwei Lagerungselementpaare 30, von denen jedes so, wie anhand der Fign. 2 und 3 gezeigt, ausgeführt ist.

In den Fign. 2 bis 4 ist auch noch Sensorik und Elektronik angedeutet, die für die Erkennung einer Berührung der Bedienleiste 18 bzw. für die Erkennung einer validen Betätigung der Bedienleiste 18 eingesetzt werden. Gemäß den Fign. 2 und 4 weist die Bedienleiste 18 entweder mehrere Kraft- bzw. Wegsensoren 56 (im Ausführungsbeispiel vier derartige Sensoren) auf, die über die Länge bzw. Breite der Bedienleiste 18 verteilt angeordnet sind. Diese Sensoren erkennen den Grad einer Verformung bzw. Bewegung von Bereichen der Bedienleiste 18 bei deren Betätigung, wodurch einerseits eine valide Betätigung der Bedienleiste 18 und andererseits aber auch anhand des Messwertbildes dieser Sensoren 56 erkannt werden kann, an welcher Stelle die Bedienleiste 18 betätigt worden ist. Alternativ zu der Positionserkennung über die mehreren Sensoren 56 kann die Bedienleiste 18 auch eine berührungssensitive Folie 58 aufweisen, was in den Fign. 2 und 4 gestrichelt angedeutet ist. Bei dieser Art der Positionsselektion bedarf es dann in jedem Fall aber auch noch mindestens eines Kraft- bzw. Wegsensors, um eine valide Betätigung der Bedienleiste 18, d.h. um das Mindestbewegungsmaß der Bedienleiste 18 zur Auslösung einer Bedienfunktion zu erkennen.

In beiden Fällen werden die Signale der Sensorik einer Auswerte- und Ansteuereinheit 60 zugeleitet, die beispielsweise einen Mikrocontroller mit entsprechender Peripherie und Bauteilen (wie I/O-Schnittstellen, CPU und Speichern) aufweist. Bei Erkennung einer validen Betätigung der Bedienleiste 18 kann die Auswerte- und Ansteuereinheit 60 beispielsweise an einen Aktuator 64 ein Ansteuersignal zur pulsartigen mechanischen Anregung der Bedienleiste 18 bzw. des Trägerelements 24 ausgeben, um auf diese Art und Weise eine taktile Rückmeldung zur Bestätigung einer gültigen Betätigung der Bedienleiste 18 auszugeben. Derartige haptische Rückmeldesysteme sind im Stand der Technik grundsätzlich bekannt. In diesem Ausführungsbeispiel ist dieses Rückmeldesystem aktiv. Man könnte aber auch ein passives Rückmeldesystem vorsehen, das beispielsweise einen Taster o.dgl. mechanischem Schalter aufweist, dessen Weg-Kraft-Kennlinie zur Erzeugung der haptischen Rückmeldung genutzt wird.

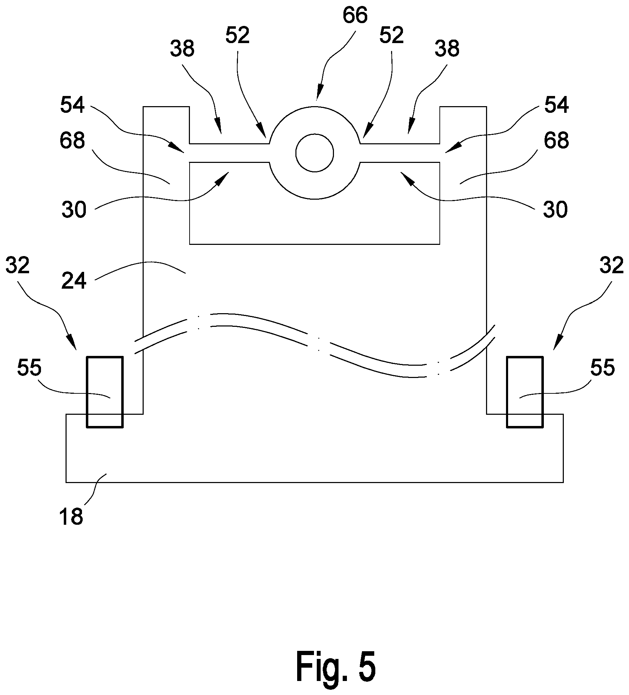

In den Fign. 5 bis 11 sind schematisch weitere Alternativen der Ausgestaltung der hinteren Lagerungselemente 32 gezeigt, wobei diese hinteren Lagerungselemente 32 einteilig mit dem typischerweise Kunststoff aufweisenden Trägerelement 24 ausgebildet sind. Sofern in den Fign. 5 bis 11 Bestandteile des Trägerelements 24 und der hinteren Lagerungselemente 30 gezeigt sind, die konstruktiv oder funktional gleich denen der Fign. 2 bis 4 sind, sind sie in den Fign. 5 bis 11 mit den gleichen Bezugszeichen wie in den Fign. 2 bis 4 bezeichnet.

In Fig. 5 ist gezeigt, wie sich die Streben 38 (mit z.B. rechteckigem Querschnitt und aus z.B. Kunststoff) der beiden hinteren Lagerungselemente 30 von einem zentralen Befestigungselement 66 aus in diametral entgegengesetzten Richtungen bis zur ihren Verbindungsenden 54 an den Innenseiten zweier Trägerarme 68 erstrecken. Das zentrale Befestigungselement 66 ist starr im (nicht gezeigten) Gehäuse befestigt. Wird nun auf die Bedienleiste 18 Kraft ausgeübt, tordieren die Streben 38 zwischen ihren Befestigungsenden 52 und ihren Verbindungsenden 54 elastisch, wobei für die Zurückbewegung zusätzlich noch die vorderen Lagerungsenden 32, d.h. deren Blattfedern 55 in Form von Federzungen, sorgen.

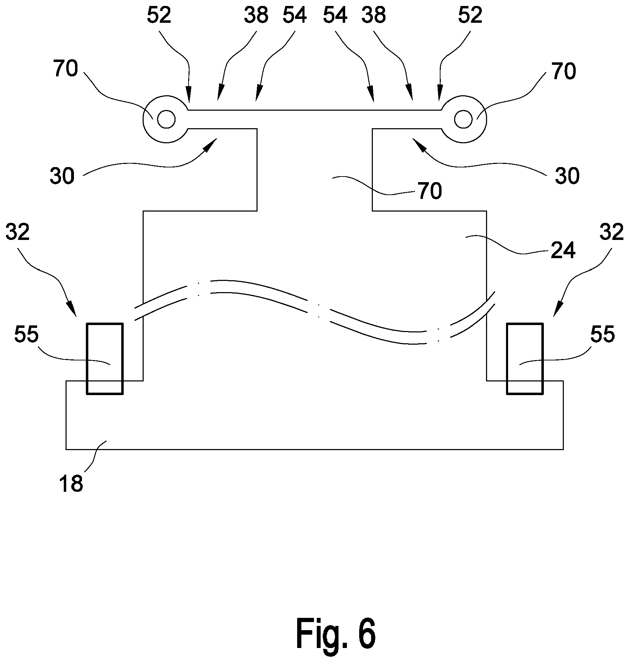

In Fig. 6 ist ein Ausführungsbeispiel gezeigt, bei dem ausgehend von einem zentralen hinteren Fortsatz 69 des Trägerelements 24 seitlich die Streben 38 (z.B. ebenfalls aus Kunststoff und im Querschnitt rechteckig) zweier hinterer Lagerungselemente 30 diametral entgegengesetzt abstehen. An ihren außenliegenden Befestigungsenden 52 sind die beiden Streben 38 mit Befestigungsblöcken 70 verbunden, die ihrerseits fest im Gehäuse befestigt sind. Bei einer Auslenkung der Bedienleiste 18 tordieren die Streben 38, was wiederum rückgängig gemacht wird, wenn die Krafteinwirkung auf die Bedienleiste 18 beendet ist.

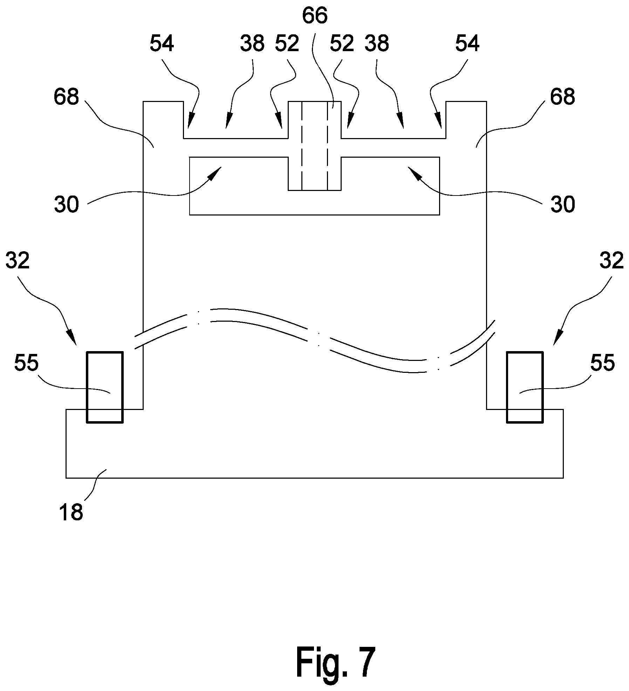

Fig. 7 zeigt eine Variante der Ausbildung der hinteren Lagerungselemente 30 ähnlich derjenigen gemäß Fig. 5. Das zentrale Befestigungselement 66 ist gegenüber der Ausführungsform nach Fig. 5 um 90° gedreht und ist beispielsweise an der hinteren Gehäusewand (nicht gezeigt) befestigt.

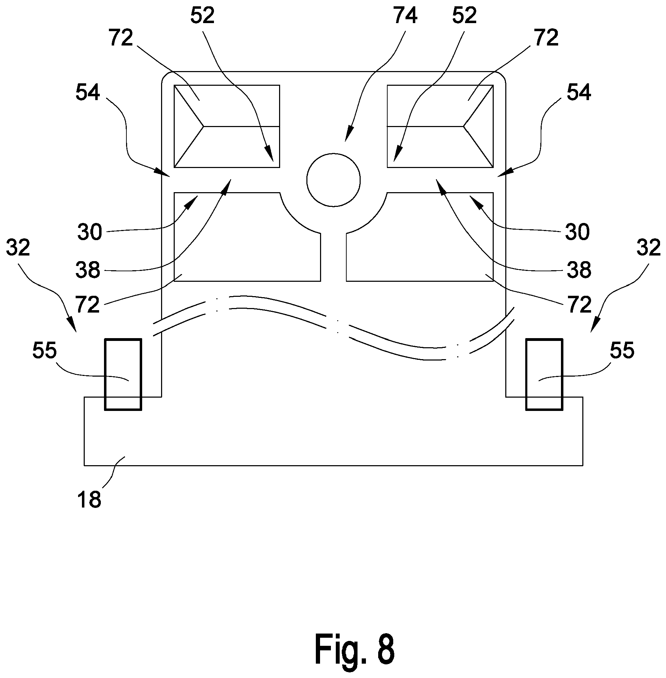

In Fig. 8 ist ein Aufbau des hinteren Endes des Trägerelements 24 gezeigt, bei dem dieses mit Durchbrüchen 72 versehen ist, die zum Teil als einseitig offene Aussparungen ausgeführt sind. Dadurch entstehen tordierbare Streben 38, die wiederum die hinteren Lagerungselemente 30 bilden. Befestigt im Gehäuse ist die Konstruktion an dem mittleren Befestigungsblock 74. Bei Krafteinwirkung auf die Bedienleiste 18 verformt sich der hintere Bereich des Trägerelements 24 elastisch.

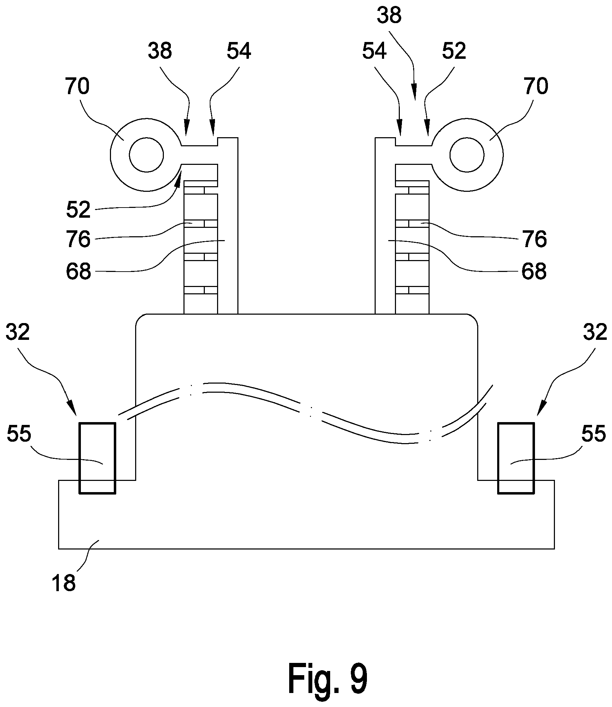

Fig. 9 zeigt eine Ausgestaltung ähnlich der nach Fig. 6, so dass insoweit konstruktiv bzw. funktional gleiche Teile mit den gleichen Bezugszeichen versehen sind. Auch in diesem Ausführungsbeispiel erstrecken sich vom hinteren Ende des Trägerelements zwei Trägerarme 68, die durch Rippen 76 versteift sind. Die tordierbaren Streben 38 erstrecken sich von den Enden der Trägerarme 68 bis zu den Befestigungsblöcken 70 und verhalten sich genau so, wie z.B. im Zusammenhang mit Fig. 6 beschrieben.

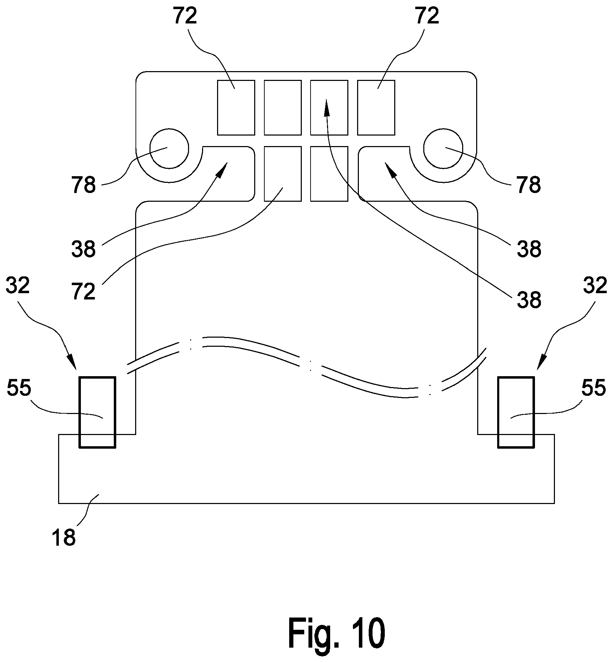

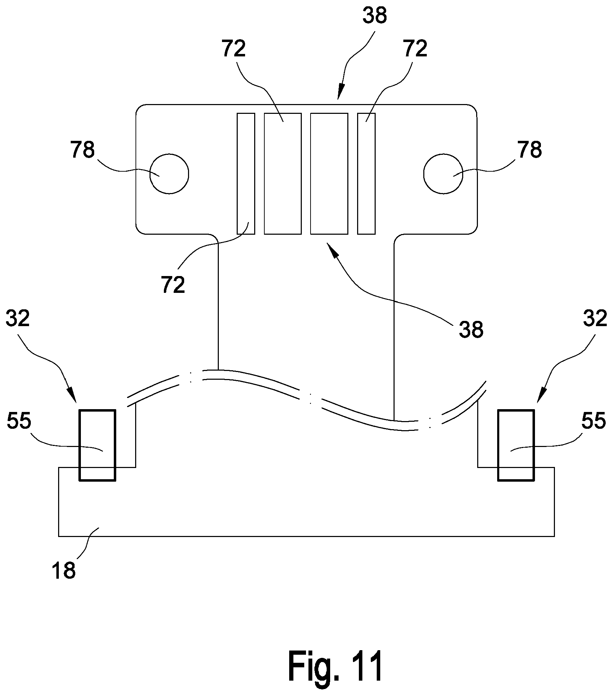

In den Fign. 10 und 11 sind Ausführungsformen des hinteren Endes des Trägerelements 24 gezeigt, die mit mehreren Durchbrüchen 72 versehen sind. Hierdurch entstehen tordierbare Streben 38, die sich elastisch verformen, wenn die Bedienleiste 18 gedrückt oder angehoben wird. Mit 78 sind in den Fign. 10 und 11 die Befestigungspunkte bzw. Befestigungsstellen gekennzeichnet, an denen die hintere Konstruktion der Trägerelemente 24 im Gehäuse befestigt sind. Neben der elastischen Ausbildung durch die Durchbrüche 72 wird beispielsweise im Ausführungsbeispiel der Fig. 11 die elastische Lagerung auch durch die vergleichsweise schmale Ausgestaltung des Trägerelements 24 selbst unterstützt.

### BEZUGSZEICHENLISTE

- 10: Bedieneinheit
- 12: Gehäuse
- 14: Vorderseite
- 16: Öffnung
- 18: Bedienleiste
- 20: Bedienfelder
- 22: Lateralenden der Bedienleiste
- 24: Trägerelement für die Bedienleiste
- 26: Öffnung im Gehäuse
- 28: hinteres Ende des Trägerelements
- 30: hinteres Lagerungselement
- 32: vorderen Lagerungselement
- 34: Lagerungsvorrichtung
- 36: Seitenränder des Trägerelements
- 38: Strebe des hinteren Lagerungselements
- 40: Flachmaterialstreifen
- 42: Blattfeder des hinteren Lagerungselements
- 43: tordierbarer Bereich der Blattfeder
- 44: gedachte Verbindungslinie
- 46: Hauptseitenfläche der Blattfeder des hinteren Lagerungselements
- 48: Hauptseitenflächen der Blattfeder des hinteren Lagerungselements
- 50: Befestigungselement für die Blattfeder des hinteren Lagerungselements
- 52: Befestigungsende der Strebe
- 54: Verbindungsende der Strebe
- 55: Blattfeder (Federzunge) des vorderen Lagerungselements
- 56: Weg- bzw. Kraftsensor
- 58: berührungsempfindliche Folie
- 60: Auswerte- und Ansteuereinheit
- 64: Aktuator
- 66: zentrales Befestigungselement
- 68: Trägerarm des Trägerelements
- 69: zentraler hinterer Fortsatz des Trägerelements
- 70: Befestigungsblock
- 72: Durchbrüche
- 74: Befestigungsblock
- 76: Versteifungsrippen
- 78: Befestigungspunkte des Trägerelements im Gehäuse

## Patentansprüche

1. Bedieneinheit für ein Fahrzeug, insbesondere für die Bedienung einer oder mehrerer Komponenten des Fahrzeugs, wie z.B. zentrale Eingabevorrichtung (CID), mit
- einem Gehäuse (12), das eine Vorderseite (14) aufweist,
- einer über die Vorderseite (14) vorstehenden, zwischen einer Ruheposition und einer Betätigungsposition bewegbaren Bedienleiste (18), die eine Bedienfläche mit mehreren in Längserstreckung der Bedienleiste (18) sowie zwischen zwei Lateralenden (22) der Bedienleiste (18) nebeneinander angeordneten, manuell oder mittels eines Betätigungsobjekts betätigbaren Bedienfeldern (20) für die Auslösung von Bedienfunktionen aufweist,
- einer Sensorik (56,58) zur Erkennung der Betätigungsposition auf der Bedienfläche der Bedienleiste (18) und zur Erkennung einer validen Betätigung der Bedienleiste (18),
- einem mit der Bedienleiste (18) verbundenen Trägerelement (24), das sich ausgehend von der Bedienleiste (18) weiter in das Gehäuse (12) hinein erstreckt und ein der Bedienleiste (18) abgewandtes hinteres Ende (28) sowie zwei zu den Lateralenden (22) der Bedienleiste (18) benachbarte Seitenenden (36) aufweist, und
- einer in dem Gehäuse (12) angeordneten Lagerungsvorrichtung (34) zur beweglichen Lagerung des Trägerelements (24) bei sich aus der Ruheposition in die Betätigungsposition sowie bei sich zurückbewegenden Bedienleiste (18), wobei das Trägerelement (24) an der Lagerungsvorrichtung (34) rückstellfähig beweglich gelagert ist,
- **dadurch gekennzeichnet, dass** die Lagerungsvorrichtung (34) mindestens ein hinteres Lagerungselement (30) für das hintere Ende (28) des Trägerelements (24) und mindestens ein vorderes Lagerungselement (32) aufweist, das mit dem der Bedienleiste (18) zugewandten Ende des Trägerelements (24) und/oder mit der Bedienleiste (18) zusammenwirkt und elastisch ausgebildet ist, und
- wobei das mindestens eine oder jedes hintere Lagerungselement (30) eine elastisch tordierbare Strebe (38) mit einer Längsachse aufweist, die sich im Wesentlichen parallel zu einer die beiden Lateralenden (22) der Bedienleiste (18) verbindenden, gedachten Verbindungslinie (44) zwischen einem Befestigungsende (52) des hinteren Lagerungselements (30), an dem die Strebe (38) innerhalb des Gehäuses (12) starr befestigt ist, und einem Verbindungsende (54) des hinteren Lagerungselements (30), an dem die Strebe (38) mit dem hinteren Ende (28) des Trägerelements (24) starr verbunden ist, erstreckt.

2. Bedieneinheit nach Anspruch 1, **dadurch gekennzeichnet, dass** die Strebe (38) des mindestens einen oder jedes hinteren Lagerungselements (30) als Stab mit rundem oder mit mehreckigem Querschnitt ausgebildet ist.

3. Bedieneinheit nach Anspruch 1, **dadurch gekennzeichnet, dass** die Strebe (38) des mindestens einen oder jedes hinteren Lagerungselements (30) als Flachmaterialstreifen (40) mit zwei Hauptseitenflächen (46,48) ausgebildet ist und dass die Hauptseitenflächen (46,48) des Flachmaterialstreifens (40) vertikal ausgerichtet oder gegenüber der Vertikalen um weniger als 45° gekippt ausgerichtet sind.

4. Bedieneinheit nach einem der Ansprüche 1 bis 3, **dadurch gekennzeichnet, dass** die Lagerungsvorrichtung (34) zwei hintere Lagerungselemente (30) aufweist, deren beide Streben (38) sich von einem gemeinsamen Befestigungsende (52) aus in entgegengesetzten Richtungen zu ihren jeweiligen Verbindungsenden (54) erstrecken, an denen sie mit dem hinteren Ende (28) des Trägerelements (24) starr verbunden sind.

5. Bedieneinheit nach Anspruch 4, **dadurch gekennzeichnet, dass** die beiden Streben (38) an ihren Befestigungsenden (52) zur Bildung einer gemeinsamen Strebe (38) einstückig miteinander verbunden sind und einen Mittenbefestigungsabschnitt der gemeinsamen Strebe (38) definieren, von dem aus sich die gemeinsame Strebe (38) in zwei zueinander entgegengesetzten Richtungen zu ihren mit dem Trägerelement (24) verbundenen Verbindungsenden (54) erstreckt.

6. Bedieneinheit nach einem der Ansprüche 1 bis 4, **dadurch gekennzeichnet, dass** die Lagerungsvorrichtung (34) zwei hintere Lagerungselemente (30) aufweist, deren beide Streben (38) ausgehend von einem gemeinsamen Verbindungsende (54), an dem sie mit dem Trägerelement (24) verbunden sind, sich in entgegengesetzten Richtungen zu ihren jeweiligen Befestigungsenden (52) erstrecken, an denen sie innerhalb des Gehäuses (12) direkt oder indirekt starr befestigt sind.

7. Bedieneinheit nach Anspruch 6, **dadurch gekennzeichnet, dass** die beiden Streben (38) an ihren Verbindungsenden (54) zur Bildung einer gemeinsamen Strebe (38) einstückig miteinander verbunden sind und einen Mittenverbindungsabschnitt der gemeinsamen Strebe (38) definieren, innerhalb dessen die gemeinsame Strebe (38) mit dem Trägerelement (24) verbunden ist und von dem aus sich die gemeinsame Strebe (38) in zwei zueinander entgegengesetzten Richtungen zu ihren innerhalb des Gehäuses (12) direkt oder indirekt starr befestigten Befestigungsenden (52) erstreckt.

8. Bedieneinheit nach einem der Ansprüche 1 bis 7, **dadurch gekennzeichnet, dass** das Trägerelement (24) nach Art einer Platte ausgebildet ist, die bezogen auf die Längserstreckung der Bedienleiste (18) mittenzentriert zu dieser angeordnet ist.

9. Bedieneinheit nach einem der Ansprüche 1 bis 7, **dadurch gekennzeichnet, dass** das Trägerelement (24) zwei mit der Bedienleiste (18) verbundene Trägerarme (68) aufweist oder dass von dem hinteren Ende (28) des Trägerelements (24) zwei Trägerarme (68) abstehen, wobei die Trägerarme (68) symmetrisch zu einer quer zur Erstreckung der Bedienleiste (18) durch deren Mitte verlaufende, gedachten Symmetrielinie angeordnet sind, und dass an jedem Trägerarm (68) an dessen jeweils der Bedienleiste (18) abgewandten hinteren Ende (28) ein hinteres Lagerungselement (30) angeordnet ist.

10. Bedieneinheit nach einem der Ansprüche 1 bis 9, **dadurch gekennzeichnet, dass** die Lagerungsvorrichtung (34) zwei vordere Lagerungselemente (32) aufweist, die an den beiden Seitenenden (36) des Trägerelements (24) oder den beiden Lateralenden (22) der Bedienleiste (18) einander gegenüberliegend angeordnet sind.

11. Bedieneinheit nach einem der Ansprüche 1 bis 10, **dadurch gekennzeichnet, dass** das mindestens eine oder jedes hintere Lagerungselement (30) integraler Bestandteil des hinteren Endes (28) des Trägerelements (24) oder, sofern das Trägerelement (24) Trägerarme (68) aufweist, integraler Bestandteil der hinteren Enden der Trägerarme (68) des Trägerelements (24) ist.

12. Bedieneinheit nach einem der Ansprüche 1 bis 11, **dadurch gekennzeichnet, dass** die Strebe (38) des mindestens einen oder jedes hinteren Lagerungselements (30) als eine Blattfeder (42) aus Kunststoff oder Federstahl ausgebildet ist.

13. Bedieneinheit nach einem der Ansprüche 1 bis 12, **dadurch gekennzeichnet, dass** das mindestens eine oder jedes vordere Lagerungselement (32) als Blattfeder (55) aus Kunststoff oder Federstahl oder als Schraubenfeder aus Kunststoff oder Federstahl ausgebildet ist.

14. Bedieneinheit nach einem der Ansprüche 1 bis 13, **dadurch gekennzeichnet, dass** die Sensorik mindestens zwei Kraft- und/oder Wegsensoren (56) zur Erfassung der Kraft, die bei Betätigung der Bedienleiste (18) auf diese einwirkt, und/oder des Weges, um den sich die Bedienleiste (18) bei Betätigung bewegt, und eine Auswerteeinheit (60) aufweist, die von den Sensoren (56) Messsignale empfängt und anhand dieser Messsignale ein die Betätigungsposition auf der Bedienleiste (18) repräsentierendes Signal und ein eine valide Betätigung der Bedienleiste (18) repräsentierendes Signal erzeugt.

15. Bedieneinheit nach einem der Ansprüche 1 bis 13, **dadurch gekennzeichnet, dass** die Sensorik eine in der oder auf der Bedienleiste (18) angeordnete berührungssensitive Folie (58), die bei Berührung und/oder Betätigung der Bedienleiste (18) ein die Betätigungsposition repräsentierendes Signal ausgibt, sowie mindestens einen Kraft- und/oder Wegsensor (56) zur Erfassung der Kraft, die bei Betätigung der Bedienleiste (18) auf diese einwirkt, und/oder des Weges, um den sich die Bedienleiste (18) bei Bestätigung bewegt, und eine Auswerteeinheit (60) aufweisen, die von dem mindestens einen Sensor (56) und der berührungssensitiven Folie (58) Signale empfängt und anhand dieser Signale ein die Betätigungsposition auf der Bedienleiste (18) repräsentierendes Signal und ein eine valide Betätigung der Bedienleiste (18) repräsentierendes Signal erzeugt.

16. Bedieneinheit nach einem der Ansprüche 1 bis 15, **gekennzeichnet durch**
- eine Anzeigeeinheit mit einer oberhalb und/oder unterhalb der Bedienleiste (18) angeordneten Anzeigefläche zur Anzeige von alphanummerischer und/oder grafischer Information betreffend die dem jeweiligen Betätigungsfeld (20) zugeordneten Bedienfunktionen oder
- eine in der Bedienleiste (18) integrierte Anzeigeeinheit mit Anzeigefläche zur Anzeige von alphanummerischer und/oder grafischer Information betreffend die dem jeweiligen Bedienfeld (20) zugeordnete Bedienfunktion oder
- unveränderbare alphanummerische und/oder grafische Information, z.B. in Form von Symbolen, Icons o.dgl. auf der Bedienleiste (18).

17. Bedieneinheit nach einem der Ansprüche 1 bis 16, **gekennzeichnet durch** eine passive oder aktive Haptik-Rückmeldeeinheit mit einem Aktuator (64) zur Erzeugung einer akustischen und/oder taktilen Rückmeldung bei einer gültigen Betätigung der Bedienleiste (18).

## Claims

1. An operating unit for a vehicle, in particular for operating one or several components of the vehicle, such as a central input device (CID), comprising
- a housing (12) having a front side (14),
- an operating panel (18) projecting beyond the front side (14) and movable between a rest position and an actuating position, said operating panel having an operating surface with several operating fields (20) for triggering operating functions, which operating fields are arranged next to one another in the longitudinal extension of the operating panel (18) and between two lateral ends (22) of the operating panel (18) and can be actuated manually or by means of an actuating object,
- a sensor system (56, 58) for detecting the actuating position of the operating surface of the operating panel (18) and for detecting a valid actuation of the operating panel (18),
- a support member (24) connected to the operating panel (18), which extends from the operating panel (18) further into the housing (12) and has a rear end (28) facing away from the operating panel (18) and two side ends (36) adjacent to the lateral ends (22) of the operating panel (18), and
- a mounting device (34) arranged in the housing (12) for movable mounting of the support member (24) when the operating panel (18) moves from the rest position to the actuating position and moves back, wherein the support member (24) is movably mounted on the mounting device (34) so that it can be reset,
- **characterized in that** the mounting device (34) comprises at least one rear mounting member (30) for the rear end (28) of the support member (24) and at least one front mounting member (32) which interacts with the end of the support member (24) facing the operating panel (18) and/or with the operating panel (18) and is of elastic design, and
- wherein the at least one or each rear mounting member (30) comprises an elastically twistable strut (38) having a longitudinal axis extending substantially parallel to an imaginary connecting line (44) connecting the two lateral ends (22) of the operating panel (18) between a mounting end (52) of the rear mounting member (30) at which the strut (38) is rigidly fixed inside the housing (12) and a connecting end (54) of the rear mounting member (30) at which the strut (38) is rigidly connected to the rear end (28) of the support member (24).

2. The operating unit according to claim 1, **characterized in that** the strut (38) of the at least one or each rear mounting member (30) is formed as a rod with a round or polygonal cross-section.

3. The operating unit according to claim 1, **characterized in that** the strut (38) of the at least one or each rear mounting member (30) is formed as a flat material strip (40) having two main side surfaces (46, 48), and that the main side surfaces (46, 48) of the flat material strip (40) are vertically aligned or tilted by less than 45° with respect to the vertical.

4. The operating unit according to any one of claims 1 to 3, **characterized in that** the mounting device (34) has two rear mounting members (30), the two struts (38) of which extend from a common fixing end (52) in opposite directions to their respective connecting ends (54), at which they are rigidly connected to the rear end (28) of the support member (24).

5. The operating unit according to claim 4, **characterized in that** the two struts (38) are integrally connected to each other at their fixing ends (52) to form a common strut (38) and to define a central fixing portion of the common strut (38), from which the common strut (38) extends in two mutually opposite directions to its connecting ends (54) connected to the support member (24).

6. The operating unit according to any one of claims 1 to 4, **characterized in that** the mounting device (34) has two rear mounting members (30), the two struts (38) of which extend from a common connecting end (54), at which they are connected to the support member (24), in opposite directions to their respective fixing ends (52), at which they are rigidly fixed directly or indirectly inside the housing (12).

7. The operating unit according to claim 6, **characterized in that** the two struts (38) are integrally connected to each other at their connecting ends (54) to form a common strut (38) and define a central connecting portion of the common strut (38), inside which the common strut (38) is connected to the support member (24) and from which the common strut (38) extends in two mutually opposite directions to its fixing ends (52) rigidly fixed directly or indirectly inside the housing (12).

8. The operating unit according to any one of claims 1 to 7 **characterized in that** the support member (24) is designed in the form of a plate which is arranged centered in relation to the longitudinal extension of the operating panel (18).

9. The operating unit according to any one of claims 1 to 7 **characterized in that** the support member (24) has two support arms (68) connected to the operating panel (18), or that two support arms (68) project from the rear end (28) of the support member (24), wherein the support arms (68) are arranged symmetrically with respect to an imaginary line of symmetry extending transversely to the extension of the operating panel (18) through its center, and that a rear mounting member (30) is arranged on each support arm (68) at its rear end (28) facing away from the operating panel (18).

10. The operating unit according to any one of claims 1 to 9, **characterized in that** the mounting device (34) has two front mounting members (32) which are arranged opposite each other on the two side ends (36) of the support member (24) or the two lateral ends (22) of the operating panel (18).

11. The operating unit according to any one of claims 1 to 10, **characterized in that** the at least one or each rear mounting member (30) is an integral part of the rear end (28) of the support member (24) or, if the support member (24) has support arms (68), is an integral part of the rear ends of the support arms (68) of the support member (24).

12. The operating unit according to any one of claims 1 to 11, **characterized in that** the strut (38) of the at least one or each rear mounting member (30) is formed as a leaf spring (42) made of plastic or spring steel.

13. The operating unit according to any one of clams 1 to 12, **characterized in that** the at least one or each front mounting member (32) is formed as a spring leaf (55) made of plastic or spring steel or as a coil spring made of plastic or spring steel.

14. The operating unit according to any one of claims 1 to 13, **characterized in that** the sensor system has at least two force and/or distance sensors (56) for detecting the force that acts on the operating panel (18) when it is actuated and/or the distance by which the operating panel (18) moves when it is actuated, and an evaluation unit (60) that receives measurement signals from the sensors (56) and uses these measurement signals to generate a signal representing the actuating position on the operating panel (18) and a signal representing a valid actuation of the operating panel (18).

15. The operating unit according to any one of claims 1 to 13, **characterized in that** the sensor system has a touch-sensitive film (58) arranged in or on the operating panel (18), which emits a signal representing the actuating position when the operating panel (18) is touched and/or actuated, as well as at least one force and/or distance sensor (56) for detecting the force acting on the operating panel (18) when it is actuated, and/or the distance by which the operating panel (18) moves when it is actuated, and an evaluation unit (60) that receives signals from the at least one sensor (56) and the touch-sensitive film (58) and uses these signals to generate a signal representing the actuating position on the operating panel (18) and a signal representing a valid actuation of the operating panel (18).

16. The operating unit according to any one of claims 1 to 15, **characterized by**
- a display unit with a display surface arranged above and/or below the operating panel (18) for displaying alphanumeric and/or graphic information relating to the operating functions assigned to the respective operating field (20), or
- a display unit integrated in the operating panel (18) with a display surface for displaying alphanumeric and/or graphic information relating to the operating function assigned to the respective operating field (20), or
- unchangeable alphanumeric and/or graphic information, e.g. in the form of symbols, icons or the like on the operating panel (18).

17. The operating unit according to any one of claims 1 to 16, **characterized by** a passive or active haptic feedback unit comprising an actuator (64) for generating an acoustic and/or tactile feedback upon a valid actuation of the operating panel (18).

## Revendications

1. Unité de commande pour un véhicule, en particulier pour la commande d'un ou plusieurs composants du véhicule, tels que le dispositif d'entrée central (CID), avec
- un boîtier (12) qui présente une face avant (14),
- une barre de commande (18) dépassant de la face avant (14), pouvant être déplacée entre une position de repos et une position d'actionnement, qui présente une surface de commande avec plusieurs panneaux de commande (20) disposés côte à côte dans l'extension longitudinale de la barre de commande (18) ainsi qu'entre deux extrémités latérales (22) de la barre de commande (18), pouvant être actionnés manuellement ou au moyen d'un objet d'actionnement pour le déclenchement de fonctions de commande,
- un système de capteurs (56, 58) pour identifier la position d'actionnement sur la surface de commande de la barre de commande (18) et pour identifier un actionnement valide de la barre de commande (18),
un élément porteur (24) relié à la barre de commande (18), qui s'étend davantage dans le boîtier (12) en partant de la barre de commande (18) et présente une extrémité arrière (28) opposée à la barre de commande (18) ainsi que deux extrémités latérales (36) adjacentes aux extrémités latérales (22) de la barre de commande (18), et
- un dispositif de support (34) disposé dans le boîtier (12) pour le support mobile de l'élément porteur (24) lorsque la barre de commande (18) revient de la position de repos dans la position d'actionnement, dans lequel l'élément porteur (24) est monté de manière mobile et repositionnable sur le dispositif de support (34),
**caractérisée en ce que**
le dispositif de support (34) comprend au moins un élément de support arrière (30) pour l'extrémité arrière (28) de l'élément porteur (24) et au moins un élément de support avant (32) qui interagit avec l'extrémité de l'élément porteur (24) tournée vers la barre de commande (18) et/ou avec la barre de commande (18) elle-même et qui est réalisé de manière élastique, et
- dans lequel l'au moins un ou chaque élément de support arrière (30) présente une entretoise (38) pouvant être tordue élastiquement avec un axe longitudinal qui s'étend sensiblement parallèlement à une ligne de liaison (44) imaginaire reliant les deux extrémités latérales (22) de la barre de commande (18) entre une extrémité de fixation (52) de l'élément de support arrière (30), sur laquelle l'entretoise (38) est fixée rigidement à l'intérieur du boîtier (12), et une extrémité de liaison (54) de l'élément de support arrière (30), sur laquelle l'entretoise (38) est reliée rigidement à l'extrémité arrière (28) de l'élément porteur (24).

2. Unité de commande selon la revendication 1, **caractérisée en ce que** l'entretoise (38) de l'au moins un ou de chaque élément de support arrière (30) est conçue sous forme de tige à section ronde ou polygonale.

3. Unité de commande selon la revendication 1, **caractérisée en ce que** l'entretoise (38) de l'au moins un ou de chaque élément de support arrière (30) est réalisée comme une bande de matériau plat (40) avec deux surfaces latérales principales (46, 48) et **en ce que** les surfaces latérales principales (46, 48) de la bande de matériau plat (40) sont orientées verticalement ou sont inclinées avec un basculement inférieur à 45° par rapport à la verticale.

4. Unité de commande selon l'une quelconque des revendications 1 à 3, **caractérisée en ce que** le dispositif de support (34) présente deux éléments de support arrière (30) dont les deux entretoises (38) s'étendent d'une extrémité de fixation commune (52) dans des directions opposées à leurs extrémités de liaison (54) respectives, sur lesquelles elles sont reliées rigidement à l'extrémité arrière (28) de l'élément porteur (24).

5. Unité de commande selon la revendication 4, **caractérisée en ce que** les deux entretoises (38) sont reliées entre elles en une seule pièce sur leurs extrémités de fixation (52) pour former une entretoise commune (38) et définissent une section de fixation centrale de l'entretoise commune (38) à partir de laquelle l'entretoise commune (38) s'étend dans deux directions opposées l'une à l'autre vers leurs extrémités de liaison (54) reliées à l'élément porteur (24).

6. Unité de commande selon l'une quelconque des revendications 1 à 4, **caractérisée en ce que** le dispositif de support (34) présente deux éléments de support arrière (30) dont les deux entretoises (38) s'étendent dans des directions opposées à leurs extrémités de fixation (52) respectives, sur lesquelles elles sont fixées directement ou indirectement de manière rigide à l'intérieur du boîtier (12), en partant d'une extrémité commune de liaison (54) sur laquelle elles sont reliées à l'élément porteur (24).

7. Unité de commande selon la revendication 6, **caractérisée en ce que** les deux entretoises (38) sont reliées l'une à l'autre en une seule pièce sur leurs extrémités de liaison (54) pour former une entretoise commune (38) et définissent une section de liaison centrale de l'entretoise commune (38), à l'intérieur de laquelle l'entretoise commune (38) est reliée à l'élément porteur (24) et à partir de laquelle l'entretoise commune (38) s'étend dans deux directions opposées vers ses extrémités de fixation (52) fixées de manière rigide, directement ou indirectement, à l'intérieur du boîtier (12).

8. Unité de commande selon l'une quelconque des revendications 1 à 7, **caractérisée en ce que** l'élément porteur (24) est conçu sous la forme d'une plaque, qui est disposée de manière centrée par rapport à la barre de commande (18) par rapport à l'extension longitudinale de celle-ci.

9. Unité de commande selon l'une quelconque des revendications 1 à 7, **caractérisée en ce que** l'élément porteur (24) présente deux bras porteurs (68) reliés à la barre de commande (18) ou **en ce que** deux bras porteurs (68) font saillie de l'extrémité arrière (28) de l'élément porteur (24), dans laquelle les bras porteurs (68) sont disposés symétriquement par rapport à une ligne de symétrie imaginaire s'étendant pour l'extension de la barre de commande (18) à travers son milieu, et **en ce qu'**un élément de support arrière (30) est disposé sur chaque bras porteur (68) sur son extrémité arrière (28) opposée respectivement à la barre de commande (18).

10. Unité de commande selon l'une quelconque des revendications 1 à 9, **caractérisée en ce que** le dispositif de support (34) présente deux éléments de support avant (32), qui sont disposés en vis-à-vis sur les deux extrémités latérales (36) de l'élément porteur (24) ou sur les deux extrémités latérales (22) de la barre de commande (18).

11. Unité de commande selon l'une quelconque des revendications 1 à 10, **caractérisée en ce que** l'au moins un ou chaque élément de support arrière (30) fait partie intégrante de l'extrémité arrière (28) de l'élément porteur (24) ou, dans la mesure où l'élément porteur (24) présente des bras porteurs (68), fait partie intégrante des extrémités arrière des bras porteurs (68) de l'élément porteur (24).

12. Unité de commande selon l'une quelconque des revendications 1 à 11, **caractérisée en ce que** l'entretoise (38) de l'au moins un ou de chaque élément de support arrière (30) est réalisée en tant que ressort à lames (42) en plastique ou en acier à ressorts.

13. Unité de commande selon l'une quelconque des revendications 1 à 12, **caractérisée en ce que** l'au moins un ou chaque élément de support avant (32) est réalisé en tant que ressort à lames (55) en plastique ou en acier à ressort, ou en tant que ressort hélicoïdal en plastique ou en acier à ressorts.

14. Unité de commande selon l'une quelconque des revendications 1 à 13, **caractérisée en ce que** le système de capteurs présente au moins deux capteurs de force et/ou de déplacement (56) pour détecter la force qui agit lors de l'actionnement de la barre de commande (18) sur celle-ci et/ou le déplacement de la barre de commande (18) lors de l'actionnement, et une unité d'évaluation (60) qui reçoit des signaux de mesure des capteurs (56) et génère, à partir de ces signaux de mesure, un signal représentant la position d'actionnement sur la barre de commande (18) et un signal représentant un actionnement valide de la barre de commande (18).

15. Unité de commande selon l'une quelconque des revendications 1 à 13, **caractérisée en ce que** les capteurs présentent un film tactile (58) disposé dans ou sur la barre de commande (18), qui émet lors d'un contact et/ou d'un actionnement de la barre de commande (18), un signal représentatif de la position d'actionnement, ainsi qu'au moins un capteur de force et/ou de déplacement (56) pour détecter la force, qui agit lors de l'actionnement de la barre de commande (18) sur celle-ci, et/ou la course, de laquelle la barre de commande (18) se déplace lors de la confirmation, et présentent une unité d'évaluation (60) qui reçoit des signaux de l'au moins un capteur (56) et du film tactile (58) et génère à partir de ces signaux un signal représentant la position d'actionnement sur la barre de commande (18) et un signal représentant un actionnement valide de la barre de commande (18).

16. Unité de commande selon l'une quelconque des revendications 1 à 15, **caractérisée par**
- une unité d'affichage avec une surface d'affichage disposée au-dessus et/ou en dessous de la barre de commande (18) pour l'affichage d'informations alphanumériques et/ou graphiques concernant les fonctions de commande attribuées au panneau d'actionnement (20) respectif ou
- une unité d'affichage intégrée dans la barre de commande (18) avec surface d'affichage pour l'affichage d'informations alphanumériques et/ou graphiques concernant la fonction de commande associée au panneau de commande (20) respectif ou
- des informations alphanumériques et/ou graphiques non modifiables, par exemple sous forme de symboles, d'icônes ou autres sur la barre de commande (18).

17. Unité de commande selon l'une quelconque des revendications 1 à 16, **caractérisée par** une unité de confirmation haptique passive ou active avec un actionneur (64) pour générer une confirmation acoustique et/ou tactile lors d'un actionnement valide de la barre de commande (18).
